Europäisches Patentamt

European Patent Office

Office européen des brevets

(11) Publication number: **0 430 279 A2**

(12) **EUROPEAN PATENT APPLICATION**

(21) Application number: 90122968.2

(22) Date of filing: 30.11.90

(51) Int. Cl.5: **H01L 29/73**, H01L 21/331

(30) Priority: **01.12.89 US 444586**

(43) Date of publication of application:
**05.06.91 Bulletin 91/23**

(84) Designated Contracting States:
**DE FR GB Bulletin 00/1**

(71) Applicant: **Hewlett-Packard Company**
**Mail Stop 20 B-O, 3000 Hanover Street**
**Palo Alto, California 94304(US)**

(72) Inventor: **Kamins, Theodore I.**
**4132 Thain Way**
**Palo Alto, California 94306(US)**
Inventor: **Wang, Albert**
**14369 Saddle Mount Drive**
**Los Altos, California 94022(US)**

(74) Representative: **Liesegang, Roland, Dr.-Ing. et al**
**FORRESTER & BOEHMERT**
**Widenmayerstrasse 4**
**W-8000 München 22(DE)**

(54) Si/SiGe heterojunction bipolar transistor utilizing advanced epitaxial deposition techniques and method of manufacture.

(57) A semiconductor device and the method of manufacturing that device that is a low capacitance, high speed, heterojunction semiconductor device. Such a device includes a Si substrate with a subcollector layer on top of the substrate, and a field oxide layer with a window therethrough to define the active region of the semiconductor device over a portion of the subcollector layer with a Si collector layer on top of the subcollector layer on the substrate or in the window surrounded by the field oxide. A SiGe layer is deposited non-selectively over the field oxide layer and on the collector layer in the window defining the active region. Then a dielectric layer is deposited over the SiGe layer. Finally, there are metalized contacts extending through windows in the dielectric layer above the SiGe layer and the field oxide layer making contact with the SiGe layer through one window and the subcollector layer through another window. For a transistor of the same type, the initial steps are the same and a second Si layer is deposited non-selectively over the SiGe layer before the dielectric layer is deposited with that layer now being deposited over the second Si layer. And, finally, the transistor is completed in the same way with metalized contacts extending through windows in the dielectric layer, an emitter contact above the active region making contact with the uppermost Si layer through one window, a base contact making contact with SiGe layer above the field oxide layer through a second window, and a collector contact through the field oxide layer making contact to the subcollector layer through a third window outside of the active region.

Fig. 1

# SI/SIGE HETEROJUNCTION BIPOLAR TRANSISTOR UTILIZING ADVANCED EPITAXIAL DEPOSITION TECHNIQUES AND METHOD OF MANUFACTURE

Background of the Invention

This invention relates to $Si/Si_{1-x}Ge_x$ heterojunction bipolar transistors, particularly, high speed, small size, low junction capacitance transistors.

Advanced silicon bipolar transistors suffer from the competing requirements for thin base regions to obtain high unity-gain cutoff frequencies and low-resistance base regions to achieve high maximum oscillation frequencies using a heterojunction transistor (HBT) (eg. Si/SiGe) relaxes the coupling between $f_L$, the unity gain cutoff frequency, and base resistance. By using an emitter-base heterojunction, the base doping can be increased without degrading the emitter injection efficiency, thus, improving the speed, size, and capacitance of bipolar transistors. Much of the initial work in the area of Si/SiGe HBTs was conducted by Stanford University in conjunction with Hewlett-Packard Company and was described in at least two papers. Those papers are:

J.F. Gibbons, C. A. King, J. L. Hoyt, D. B. Noble, C. M. Gronet, M. P. Scott, S. J. Rosner, G. Reid, S. Laderman, K. Nakua, J. Turner, and T. I. Kamins, "$Si/Si_{1-x}Ge_x$ heterojunction bipolar transistors fabricated by limited reaction processing, " Tech. Digest 1988 Int'n Electron Devices Meeting (San) Francisco, Dec. 11-14, 1988), pp 566-569.
C. A. King, J. L. Hoyt, C. M. Gronet, J. F. Gibbons, M. P. Scott, and J. Turner, "$Si/Si_{1-x}Ge_x$ heterojunction bipolar transistors produced by limited reaction processing," IEEE Electron Devices Lett. vol. 10, pp 52-54, February 1989.

Limited reaction processing is Stanford's method of epitaxial deposition of Si or SiGe. It is a chemical vapor deposition technique in a lamp heated system so that the wafer can be heated and cooled quickly at the beginning and end of each deposition step. While the invention and its several embodiments, could be produced using that process, they may be produced by other known processes as well.

In the processing of the semiconductor devices of the embodiments of the present invention, Si and SiGe layers are deposited either selectively or non-selectively by either limited reaction processing, or a more typical process, each of which have been disclosed in the prior art. In the development of each of the semiconductor devices of the preferred embodiments, the Si and Ge bearing gases used are dichlorosilane and germane, although other Si and Ge containing gases can be used. Prior to the establishment of the SiGe layer the temperatures that are used are those typically used in the processing of Si semiconductor devices, typically around 1000 degrees C. The SiGe layer is established at typically 625 degrees C, and the post SiGe processing of the semiconductor device is done at as low a temperature as practical, typically in the range of 800 to 850 degrees C. The percentage of Ge in the alloy layer is dictated largely by the application of the device, and is generally in the range of 10 - 30 % by atomic fraction.

Summary of the Invention

In accordance with the preferred embodiments, the present invention includes both a method of making, and a low capacitance, high speed, heterojunction semiconductor device. Such a device includes a p type Si substrate with an n type subcollector layer on top of the substrate, and a field oxide layer with a window therethrough to define the active region of the semiconductor device over a portion of the subcollector layer with a collector layer on top of the subcollector layer on the substrate or in the window surrounded by the field oxide. A p type SiGe layer is deposited non-selectively over the field oxide layer and on the collector layer in window defining the active region. Then a dielectric layer is deposited over the SiGe layer. Finally, there are metalized contacts extending through windows in the dielectric layer above the SiGe layer and the field oxide layer making contact with the SiGe layer through one window and the subcollector layer through another window.

Alternatively, the preferred embodiments of the present invention includes both a method of making, and a low capacitance, high speed, heterojunction transistor. Such a device includes the above discussed layers with a second n-type Si layer deposited non-selectively over the SiGe layer. The dielectric layer is then over the second Si layer. And, finally, there are metalized contacts extending through windows in the dielectric layer, an emitter contact above the active region making contact with the second Si layer through one window, a base contact making contact with SiGe layer above the field oxide layer through a second window, and a collector contact through the field oxide layer making contact to the subcollector layer through a third window outside of the active region.

Brief Description of the Drawings

Fig. 1 is a cross-sectional schematic view of a general transistor structure that is representative of each of the embodiments of the present invention.

Figs. 2 - 10 illustrate the steps for producing a high speed transistor of the first embodiment of the present invention in cross-sectional views of a semiconductor substrate for a single transistor.

Figs. 11 - 14 illustrate the steps for producing a high speed transistor of the second embodiment of the present invention in cross-sectional views of a semiconductor substrate for a single transistor.

Figs. 15 - 18 illustrate the steps for producing a high speed transistor of the third embodiment of the present invention in cross-sectional views of a semiconductor substrate for a single transistor.

Figs. 19 - 21 illustrate the steps for producing a high speed transistor of the fourth embodiment of the present invention in cross-sectional views of a semiconductor substrate for a single transistor.

Figs. 22-25 illustrate the steps for producing a high speed transistor of the fifth embodiment of the present invention in cross-sectional views of a semiconductor substrate for a single transistor.

Description of the Preferred Embodiments

Before discussing the actual embodiments of the present invention, some general discussion and definition of terms is needed. In selective deposition, the Si or SiGe only deposits on the exposed portions of the Si substrate, not on the dielectric. In mixed deposition Si or SiGe is deposited on both the on exposed Si and on the dielectric layer. Over exposed Si the deposited Si or SiGe layer will take the form of a single crystal (epitaxial deposition), and over the dielectric, the Si or SiGe layer will take the form of a polycrystalline layer.

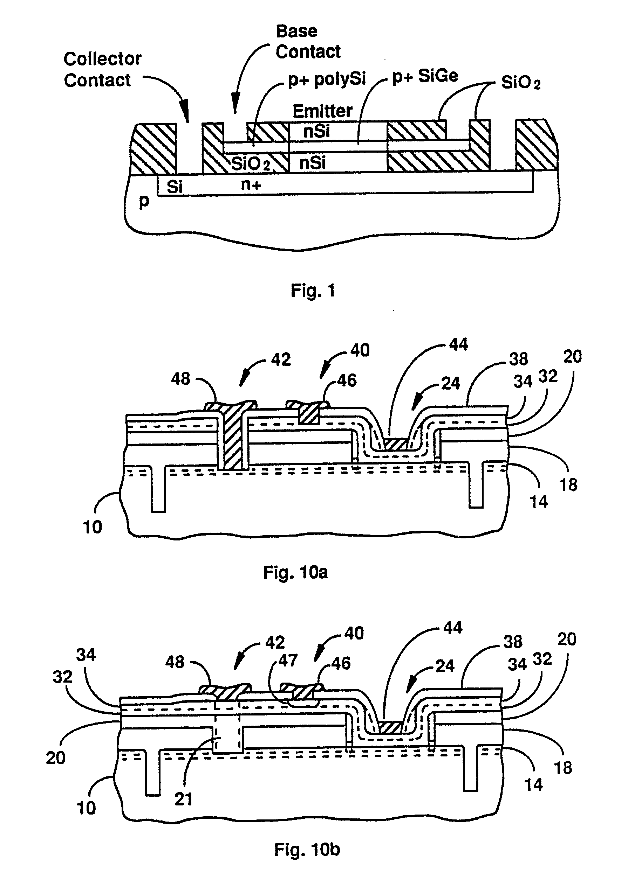

In the following discussion of the embodiments of the present invention, the figures and the discussion will be limited to the production of a single transistor on a substrate. This is done to simplify the discussion. In actual production there can be multiple transistors produced on the same substrate or wafer. After production of an individual wafer, those transistors can either be diced to produce a multiplicity of individual transistors, or the transistors can remain on the wafer with the isolation regions between them to minimize their interaction one with the other in actual use. If individual transistors are to be produced, an $n^+$ substrate is used beneath the $n^+$ collector layer, instead of a p substrate with an $n^+$ buried layer (subcollector). A representative transistor of the type of the embodiments disclosed below is shown in Fig. 1. In this structure the base connection is separated from the underlying collector region by a layer of $SiO_2$, with its low relative permittivity. The collector-base junction area is approximately the same as the emitter-base junction area; the base-collector capacitance then decreases by approximately 70% (for an oxide thickness of 500 nm), significantly increasing $f_T$ and $f_{max}$. To fabricate transistors of this design with low parasitic capacitance, advanced selective or mixed epitaxial deposition is needed. The SiGe layer can then be deposited on a partially fabricated structure, with the buried subcollector possibly the n' Si collector region and the device isolation already in place. To explore this requirement, the ability to deposit SiGe selectively using $SiH_2CL_2$ and $GeH_4$ has been investigated. An oxide mask is used to define the regions on which deposition occurs. A silicon collector layer may be first grown, followed by in-situ deposition of the SiGe layer. The deposition of the silicon layer can be selective. For some devices, the deposition of the SiGe can be selective. In other cases, the SiGe deposition can be nonselective (or mixed). In a simpler version of a Si/SiGe HBT without selective or mixed deposition, the measured value of $f_T$, was approximately 29 GHz. Advanced deposition on a partially processed wafer should markedly reduce parasitic elements and increase $f_T$.

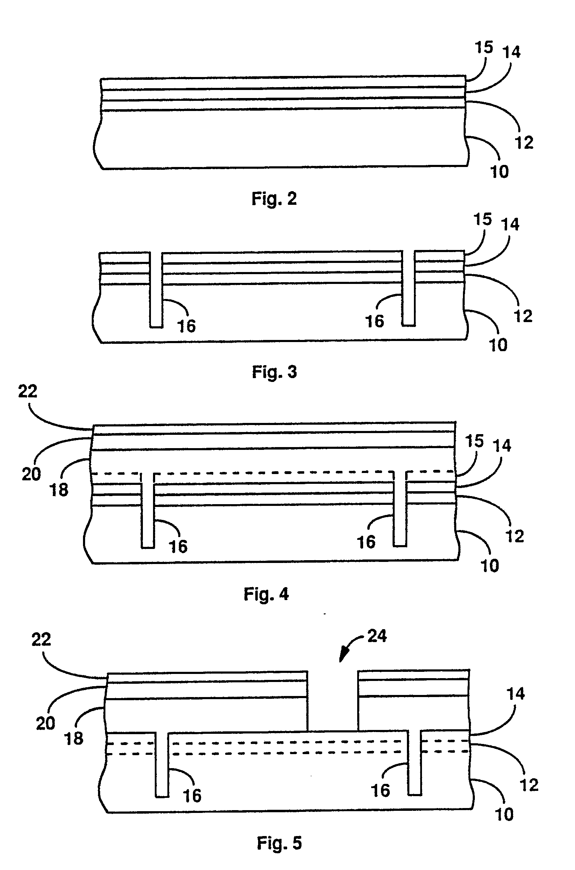

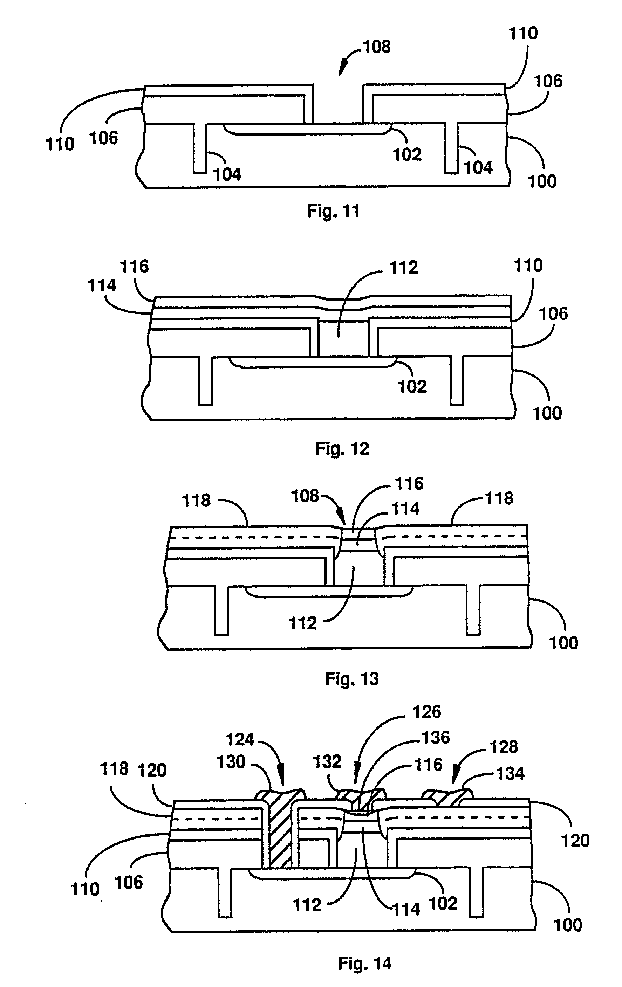

The manufacture of a transistor of the first embodiment of the present invention is shown in Figs. 2-10a and b. At various points in the following discussion, alternative techniques are discussed but not always shown in the figures. The steps shown in the figures are the preferred steps but by no means are they the only steps that may be utilized at any particular point. The transistor of the first embodiment of the present invention is produced by a combination of standard and mixed deposition techniques.

Referring to Fig. 2 there is shown, in a schematic cross-sectional view, a semiconductor substrate 10, typically with a selected (100) crystalline orientation, of a p conductivity type Si. The surface of substrate 10 is initially prepared by adding an $n^+$ layer 12 on the top surface of substrate 10 with an n' layer 14 on top of layer 12. Layer 12 can be either grown epitaxially, or it can be implanted and diffused into the top surface of substrate 10 to form the subcollector layer 12. The implant and diffusion technique is probably the technique of choice here; however, epitaxy also will produce an acceptable result. The n' layer 14 is then grown epitaxially on top of layer 12.

The next step in the process, as shown by the ordering of the figures, is the etching of the isolation trench 16 well below the top surface of substrate 10 through the $n^+$ layer into the p' substrate. An isolation trench 16 is provided to encircle each site on the wafer where a transistor is to be fabricated and there is to be more than one transistor on the completed integrated circuit. Isolation trenches 16 minimize the interaction between the various transistors through the substrate.

Trench 16 is produced by conventional means, for example by growing or depositing an oxide layer 15 on layer 14 and removing it by lithography and etching, from the areas where the trench 16 is to be formed. That is followed by the etching of the substrate 10 through the holes in the oxide layer 15. By proper control of the etch process, the walls of trenches 16 will be substantially orthogonal to the surface of substrate 10.

The next portion of the process is depicted by Fig. 4 where a thicker $SiO_2$ layer 18 is deposited on substrate 10 combining with layer 15 and also filling trenches 16. Alternately, $SiO_2$ can be formed on the bottom and sides of trenches 16, and then trenches 16 can be filled with polycrystalline Si. The polycrystalline Si is then etched from all areas but the trenches, and a field $SiO_2$ oxide layer can be regrown over the trenches so that an oxide layer covers the entire surface of the substrate 10.

A $p^+$ type polycrystalline Si layer 20 is then deposited on oxide layer 18 with a dielectric layer 22, typically of $SiO_2$, formed over poly Si layer 20. Moving on to Fig.5, a lithography technique is used to etch through layers 18-22 to expose a portion of the surface of layer 14 in the area which will become the active region 24 of the transistor when completed.

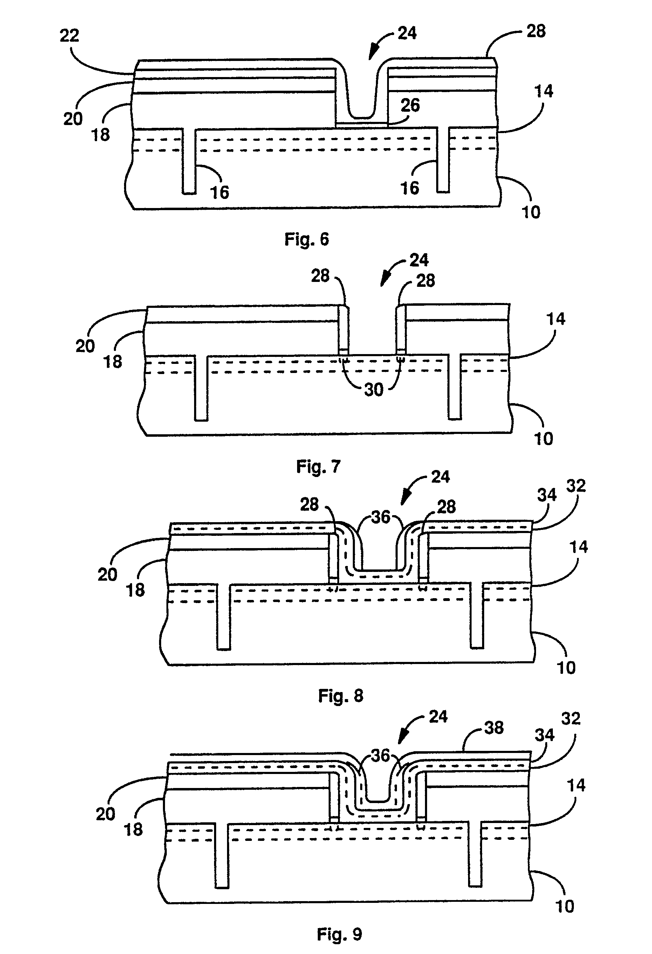

In Fig. 6 the process is continued with the formation of a dielectric layer 26, say a thermal oxide, over the entire substrate which results in the slight thickening of layer 22 outside of active region 24 and the application of a dielectric layer 26 on layer 14 in the active emitter region 24. Layers 26 and 22 each act as an etch stop in a later step. That is followed by the deposition of a $p^+$ type polycrystalline Si layer 28 over the entire substrate including the cavity (bottom and sides) of the active region 24.

Next in Fig. 7, the polysilicon layer 28 is anisotropically etched from the horizontal surfaces of layers 22 and 26. The dielectric layers 22 and 26 in this step act as the etch stops mentioned above. This results in the vertical side-walls of well 24 being poly Si. Dielectric layers 26 in the active region 24 and layer 22 in the field region are then removed by etching. In simpler versions of this process, dielectric layer 26 and possibly layer 22 may be omitted. If layer 26 is omitted, boron may be diffused from layer 28 on the sidewalls of well 24 into the intersection of the poly Si of layer 28 and layer 14 on the surface of substrate 10 which causes the $p^+$ material to extend below the top of the $n^-$ epitaxial Si layer 14. This can potentially reduce series resistance in the base and also lower junction leakage. In a further simplification, layers 22 and 28 can be omitted so that no polysilicon is formed on the sidewalls of the dielectric 18.

The process continues with Fig. 8 with the mixed deposition of a $p^+$ SiGe layer 32 over the poly Si layers 20 and 28 and the exposed single crystalline Si of layer 14 of the substrate 10. That is followed by the mixed deposition of an $n^-$ Si layer 34 on layer 32. The deposition of both of layers 32 and 34 is preferably performed by chemical vapor depositon, but can be formed by other techniques such as molecular beam epitaxy. In the finished transistor, the SiGe layer 32 will be the base layer. From this point in the process there are many different techniques that can be utilized, and the order in which those steps are performed is not critical. In following the steps depicted in the figures, the next step is the optional formation of $SiO_2$ 36 the sidewalls of well 24 as spacers. The regions outside well 24 and spacers may be doped $P^+$ type by boron implantation.

Moving next to Fig. 9 an $SiO_2$ layer 38 is shown having been formed over the entire surface of the substrate 10, including the bottom and sidewalls of well 24.

Fig. 10a shows oxide layer 38 having been opened in the emitter region 24, the base contact region 40 and the collector contact region 42, typically by a combination of lithography and etching. Emitter region 24 is etched to layer 34 which may be doped $n^+$ at least near its surface, the base contact region is etched to a p-type surface, and the collector contact region is etched to an n-type region contacting layer 12 or to layer 12 itself. Following the etching process, the emitter, base and collector contact regions are each metallized to create electrical interconnection contacts 44, 46 and 48, respectively.

Fig. 10b shows an alternative method of making contact to the bass and collector regions of the transistor of the present invention for the first embodiment. With respect to the base contact, instead of etching down to layer 32 through the window that defines the location of the base contact, boron can be doped in layer 34 through the base contact window in dielectric layer 38. This then creates a localized p type region 47 surrounded by layer 34 that extends through layer 34 to p type SiGe layer 32 Base contact 46 is then metalized as above.

Similarly, the collector connection can be done other than by etching through all of the layers to subcollector layer 12. Back where the p type poly Si layer 20 was to be deposited, a well 21 could have been opened through dielectric layer 18 so that layer 20 also filled well 21. After dielectric layer 22 was developed on poly Si layer 20, a window above well 21 could have been opened and the poly Si that extends down to sub-collector layer 12 doped with arsenic or phosphorus to create a localized n type region. Then following the addition of layers 32 and 34, just prior to the metalization step, arsenic or phosphorus could again be used to dope layer 32 n type through n type layer 34. Thus, the collector metalization can simply be made to layer 34 since an n type path through the structure to the sub-collector layer 12 was developed as the device was produced.

An advantage of the configuration of the first embodiment is that significant heat treatment is not necessary after formation of SiGe layer 32 in that nonselective Si deposition is necessary. In addition the base-collector junction near the sidewalls of the device may extend below the SiGe layer to reduce sidewall leakage.

The second embodiment of the present invention is a transistor produced by the steps depicted in Figs. 11-14.

Referring to Fig. 11, there is shown, in a schematic cross-sectional view, a semiconductor substrate 100 with a selected (100) crystalline orientation of a p⁻ conductivity type Si. The surface of substrate 100 is initially prepared by adding a sub-collector n⁺ region 102 in the top surface. Region 102 is implanted and diffused into a portion of the top surface of substrate 100, or it could be formed epitaxially, as discussed in connection with Fig 2. Isolation trenches 104 are also formed to define the transistor regions on substrate 100 in the same manner as discussed above in the development of a transistor of the first embodiment. Next a field oxide layer 106 is grown over the top surface of substrate 100, including region 102. Next, an active region well 108 is opened above one end of the sub-collector region 102 by means of lithography and etching techniques that are well known in the art. That may be followed by the formation of a nitride Si₃N₄ layer 110 on the surface of the oxide layer 106, including the side walls of well 108. To maintain the cleanliness of the critical surface between each of the next three steps, those three steps can be performed in one reactor cycle. First an n⁻ type Si layer 112 is selectively, epitaxially grown in well 108. Layer 112 will become the collector layer. The thickness of layer 112 is typically less than or equal to the thickness of oxide layer 106. Second a p⁺ type SiGe layer 114 is deposited non-selectively in mixed form over the entire surface of substrate 100. The portion of layer 114 that is substantially above layer 112 will grow epitaxially and thus have a single crystalline structure, and the portion of layer 114 above the oxide or nitride layer will have a polycrystalline structure. Layer 114, also, will become the base layer. Third, an n⁻ type Si layer 116 is nonselectively deposited in mixed form on the SiGe layer 114, and this layer will become the emitter layer. Similar to layer 114, layer 116 grows epitaxially with a single crystalline structure above the single crystalline portion of layer 114, and the remainder of layer 116 has a polycrystalline structure.

Next, as shown in Fig. 13, the polycrystalline portions and a small portion of the epitaxial portions near the polycrystalline portions of layers 114 and 116 are counter doped with boron to become p⁺ type material, or more heavily p⁺ type, indicated as layer 118. Following this step both layer 114 and layer 118 are each p⁺ type material, thus layer 118 becomes a reasonably low resistance base contact layer of the transistor. This structure limits the thickness of the base layer 118 to the combined thickness of layers 114 and 116.

The remainder of the process is to complete the electrical connections to the collector, base and emitter layers. This may be accomplished by traditional techniques and in various orders of steps. Fig. 14 illustrates one of the possible final forms that result from one of the step sequences that may be used to accomplish this. First a dielectric layer 120 is formed over layers 116 and 118. A window is then opened to establish the collector contact at 124. The well for this contact may be etched through layers 120, 118, 110 and 106 to allow electrical connection to sub-collector region 102 and thereby to collector layer 112. Alternatively, a contact may be made to an n-type region previously formed extending from the surface to the n⁺ region 102 in the conventional manner. If the first technique is used, a dielectric is then formed on the sidewalls of well 124. Next, windows are opened in dielectric layer 120 through which the emitter and base contacts will be established at points 126 and 128, respectively. An n⁺ implant 136 is made to emitter layer 116, typically using arsenic. The final step is the metalization of the component to form the collector, emitter and base contacts 130, 132 and 134, respectively. Alternately a process similar to that discussed in relation to Fig. 10b of the first embodiment could be used.

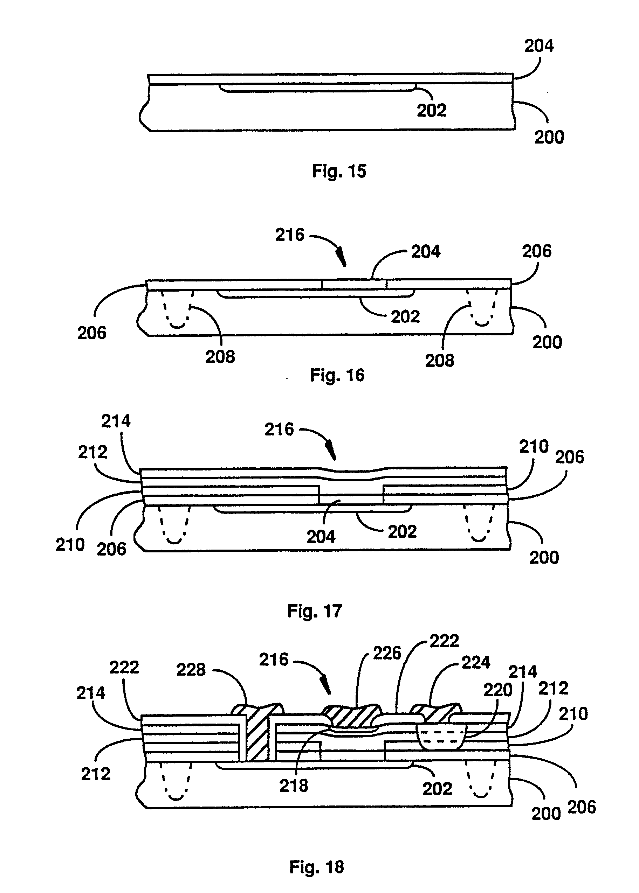

The third embodiment of the present invention is presented in Figs. 15-18. Fig. 15 shows a schematic cross-sectional view of a semiconductor substrate 200 with a selected (100) crystalline orientation of a p⁻conductivity type Si. The surface of substrate 200 is initially prepared by implanting a sub-collector n⁺ region 202 into the top surface. This could alternatively be done by epitaxial deposition as described with respect to Fig. 2. An n⁻ Si layer 204 is then grown epitaxially on the surface of substrate 200.

Referring next to Fig. 16, isolation regions 208 are formed by either diffusion or the etching of trenches by any of several well known techniques. A field oxide layer 206 is grown outside the active device region 216 by a known technique. (e.g., LOCOS or SWAMI).

As shown in Fig. 17, a Si or nitride layer 210 is grown over the surface of substrate 200 and then removed from layer 206 in the active region of the transistor. If Si is grown over the oxide layer 206 it is polycrystalline in structure and can be doped p$^+$ type. That is followed by the non-selective deposition of SiGe 212 over the surface of substrate 200, resulting in the crystalline structure being polycrystalline over layer 210 and single crystalline over layer 204. An n$^-$ Si layer 214 is next deposited over the SiGe layer 212 with layer 214 assuming the crystalline structure of the portion of layer 212 on which it was grown.

Fig. 18 then shows the finalization of the transistor of this embodiment which is nearly identical to that illustrated in Fig. 14. Layer 214 can be doped p$^+$ outside the active device region 216. An oxide layer 222 is formed on the surface of substrate 200 and windows opened where the base, emitter and collector contacts are to be located. Layer 214 is doped n$^+$ through the window in the active region 216 to form layer 218, the base contact region is doped p$^+$ to form base contact 220, and the collector contact 228 is formed through all of the layers to the sub-collector region 202. Finally, base, emitter and collector terminals 224, 226 and 228, respectively, are metallized in the appropriate locations. Alternatively, the collector and base contact regions can be developed as discussed previously.

The advantage of this structure is that selective deposition of Si is not required, thus minimizing the sidewall defects that can result from the selective deposition of Si. Another advantage that results if layer 210 is a polycrystalline Si layer above the field oxide layer 206 is the ability to choose the thickness of the base contact relatively independently to optimize the base resistance.

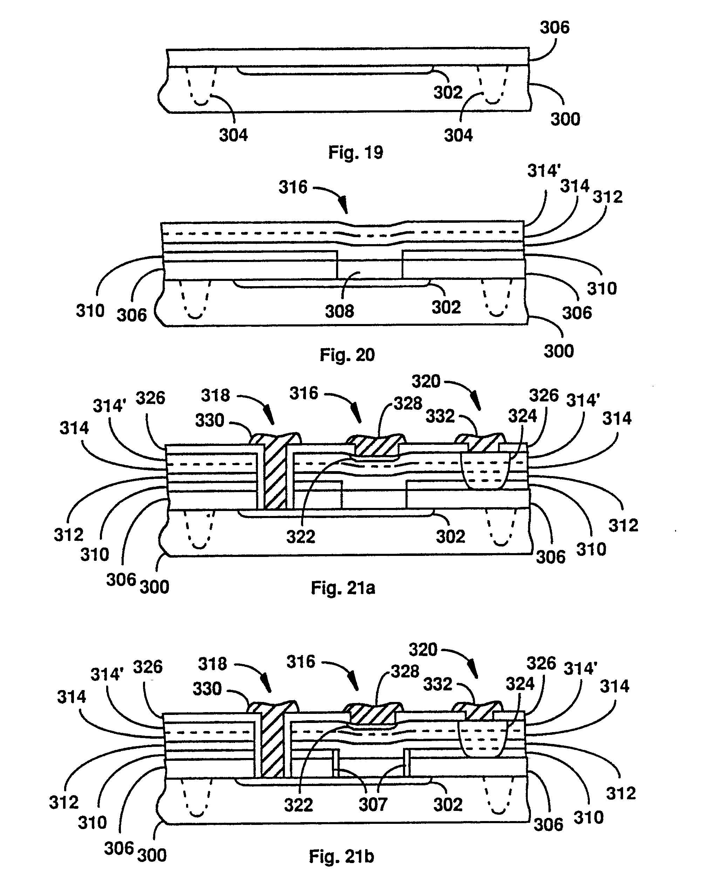

A fourth embodiment that allows further flexibility in the design of the thickness of the polycrystalline base lead is described with respect to Figs. 19-21a and b.

Fig. 19 shows a schematic cross-sectional view of a semiconductor substrate 300 with a selected (100) crystalline orientation of a p$^-$ conductivity type Si. The surface of substrate 300 is initially prepared by implanting a sub-collector n$^+$ region 302 into the top surface, followed by the diffusion or etching of isolation regions 304. This also could have been done as described with respect to Figs. 2, 3, and 16 above. A thick field oxide layer 306 of SiO$_2$ is then grown on the surface of substrate 300.

Next, in Fig. 20 a window is opened in the field oxide layer 306 to form the active region 316 of the transistor above one end of the sub-collector region 302. Then a Si collector layer 308 is grown by selective epitaxy in the active region window. A polycrystalline Si layer 310 is next formed on the field oxide layer 306 (removed from 308) leaving the top surface of layer 308 free. This poly Si layer can be made p$^+$ type. Next, a p$^+$ SiGe layer 312 is grown nonselectively so that it is epitaxial over the exposed epitaxial Si layer 308 and polycrystalline over the polycrystalline Si layer 310 that is above the field oxide layer 306. That is followed by the growth of one or two layers 314 and 314' of n type Si over SiGe layer 312.

Alternatively, poly Si layer 310 can be self aligned with collector layer 308 by processing the partially processed wafer of Fig. 19 in a different sequence of events which will produce a further processed substrate that looks the same as that produced by the above-listed steps and shown in Fig. 20. On top of the field oxide layer 306 the poly Si layer 310 is deposited, and then a dielectric layer is placed on top of poly Si layer 310. That dielectric layer can be either deposited or thermally grown. Next, lithography is used to define active region 316 by etching through the top dielectric layer, poly Si layer 310 and the underlying field oxide layer 306, down to the subcollector layer 302. Then dielectric side-walls 307 are formed in well 316. Then the Si collector layer 308 is selectively grown in the active region 316 as shown in Fig. 21b the collector layer 308 is formed, the wafer is removed from the reactor, the top dielectric layer that is on the poly Si layer 310 is removed. The substrate is then re-inserted into the reactor for deposition of the SiGe layer 312, and the Si layers 314 and 314' over the entire substrate as discussed above. Either process then continues below with the discussion of Figs. 21a and b.

Fig. 21a and b then show the finalization of the transistor of this embodiment which also is nearly identical to that illustrated in Fig. 14. First, the silicon layers 314 and 314' can be made p$^+$ outside the active region 316 oxide layer 326 is grown on the surface of substrate 300 and windows opened where the base, emitter and collector contacts are to be located. Layer 314 or 314' is doped n$^+$ through the window in the active region 316 to form layer 322, the base contact region is doped p$^+$ to form base contact 324, and the collector contact 330 is formed through all of the layers to the sub-collector region 302. Finally, base, emitter and collector terminals 332, 328 and 330, respectively, are metallized in the appropriate locations. As in the previously discussed embodiments, the collector and base contacts can be developed by other techniques.

For this configuration, since the base lead is already heavily doped p$^+$ type Si, the contact region can be separated from the device emitter region without introducing large series base resistance. Therefore, a self-aligned process for the emitter and extrinsic base is not needed.

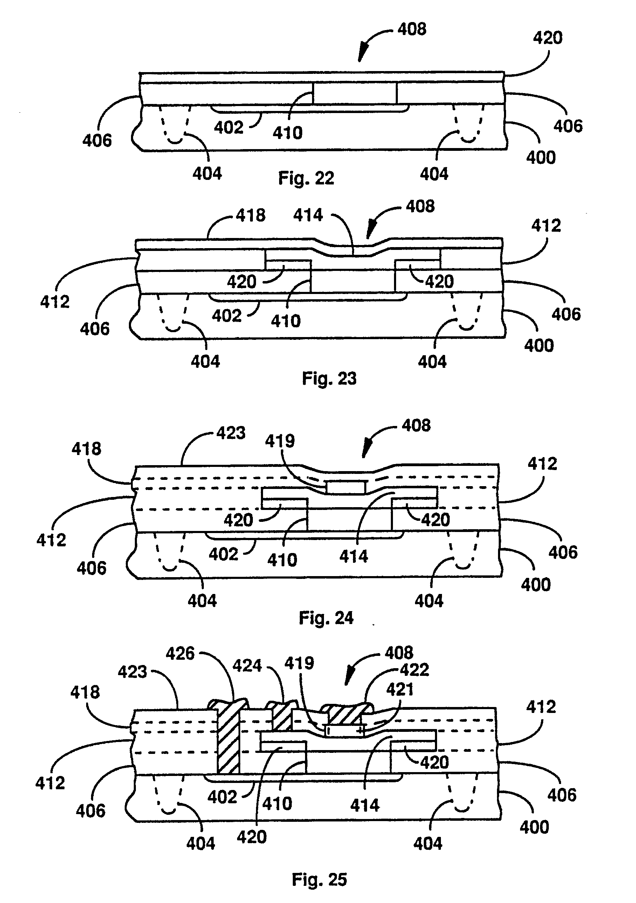

The steps for producing the fifth embodiment of the present invention are discussed below in relation to Figs. 22-25 where the results of the various process steps are illustrated schematically. In Fig. 22 the p Si substrate 404 is prepared in any of several different ways to form an n⁺ Si subcollector layer 402 and isolation regions 404. A $SiO_2$ layer 406 is then grown on the top surface of substrate 400 and a window opened through it in the active region 408. An n type Si layer 410 is then grown selectively epitaxially in window 408, followed by the deposition of a p⁺ polycrystalline Si layer 420 over the entire surface of the substrate.

Then in Fig. 23 the next step is the removal of the poly Si layer 420 both above layer 410 and over the outer reaches of dielectric layer 406 to form a ring of poly Si around layer 410. Oxide layer 412 is then deposited over the entire surface of the substrate, and a window through it is opened above both the Si layer 410 and the poly Si layer 420. Over both layers 410 and 420 a p⁺ type SiGe layer 414 is deposited with the portion of this layer above layer 410 being single crystalline and the portion above layer 420 being polycrystalline. That is then followed by the deposition of a $SiO_2$ layer 418 over the entire surface of the substrate.

In Fig. 24 the process continues with the opening of a window in dielectric layer 418 that is less than the full width of layer 410 in region 408. An n type Si layer 419 is deposited that is single crystalline. Next, another $SiO_2$ layer 423 is formed over the entire surface of the substrate.

Finally, as shown in Fig. 25, windows are opened through the $SiO_2$ layers to form the metalizations for the emitter, base and collector contacts 422, 424 and 426, respectively. In each case the window extends only through oxide to the first non-oxide layer. The emitter contact window extends to layer 419, with at least the top portion of layer 419 being heavily doped with arsenic or phosphorus to promote good electrical contact. The base window extends to layer 414, and the collector window extends to the sub-collector layer 402. The final step is then the metalization of the emitter, base and collector contacts as identified as 422, 424 and 426, respectively.

Although the silicon layer below the SiGe has been called the collector and the silicon layer above the SiGe has been called the emitter, the nearly symmetrical behavior of the transistor allows the lower silicon layer to be used as the emitter and the upper silicon layer to be used as the collector.

In each of the embodiments which have been discussed above no mention has been made as to the actual thicknesses of any of the layers. While layer thickness is important and sometimes critical to the operation of the finished device, those thicknesses are well known from the prior art, and particularly from the references cited in the Background section above.

The above-discussed processes for the production of a transistor are by no means limited to the order in which the steps were discussed, and one skilled in the semiconductor art would be knowledgeable in the reordering of the various steps to produce high-speed transistors and other semiconductor components. For example, a diode can be produced by any of the above-outlined processes by merely omitting the emitter regions which are finalized after the deposition of the SiGe layer. Therefore, the scope of the present invention is only limited by the scope of the claims and equivalents of those methods and components claimed.

## Claims

1. A semiconductor device comprising;
   a substrate (10,100);
   a subcollector region (12,102) on the substrate;
   a collector layer (14, 112) on the subcollector region;
   a field oxide layer (18,106) over the subcollector region and having a window therethrough defining an active region (24,108);
   a silicon-germanium layer (32,114) over the field oxide layer and in contact with the collector layer in the active region;
   a dielectric layer (38,120) over the silicon-germanium layer;
   means (46,128) for establishing electrical contact with the silicon-germanium layer; and
   means (48, 130) for establishing electrical contact with the collector layer.

2. A device according to claim 1 wherein the substrate comprises P type silicon, the subcollector region comprises N+ type silicon, the collector layer comprises N-type silicon, and the silicon-germanium layer comprises P type material.

3. A device according to claim 1 or 2 and further comprising an emitter layer (34, 116) between the silicon-germanium layer and the dielectric layer.

4. A device according to claim 3 wherein the emitter layer comprises N type silicon.

5. A device according to any of claims 1,2,3, or 4 wherein the collector layer (14) underlies the field oxide layer (18) and the silicon-germanium layer (32) extends into and partially fills the window.

6. A device according to any of claims 1,2,3,4, or 5 and further comprising a polycrystalline sidewall (28) adjacent vertical portions of the field oxide layer in the window.

7. A device according to any of claims 1,2,3, or 4 wherein the collector layer (112) is formed in and partially fills the window.

8. A device according to claim 7 and further comprising a nitride layer (110) between the field oxide layer (106) and the silicon-germanium layer (114).

9. A device according to claim 7 and further comprising a polycrystalline silicon layer. (310) between the field oxide layer (306) and the silicon-germanium layer (312).

10. A device according to claim 7 and further comprising:
an annular polycrystalline layer (420) between the field oxide layer (406) and the silicon-germanium layer (414) adjacent the window; and
oxide (412) extending laterally outward from the annular layer and limiting the lateral extend of the silicon-germanium layer.

11. A method of fabricating a semiconductor device, the method comprising:
(a) providing a substrate structure having an upper surface comprising a field oxide layer (18, 106) with a window therethrough, the window defining an active region (24, 108), a collector layer (14, 112) accessible through the window, a subcollector layer (12,102) beneath the collector layer, and a substrate (10,100) beneath the subcollector layer;
(b) non-selectively depositing a silicon-germanium layer (32,114) over the field oxide layer and that portion of the collector layer which is accessible through the window;
(c) depositing a dielectric layer (38, 120) over the silicon-germanium layer;
(d) opening a first contact window through the dielectric layer to the silicon-germanium layer;
(e) forming an electrical contact (46,128) with the silicon-germanium layer through the first contact window;
(f) opening a second contact window through the dielectric layer to the collector layer; and

(g) forming an electrical contact (48, 130) with the collector layer.

12. A method according to claim 11 wherein step (a) comprises:
(a1) creating the subcollector layer on the substrate;
(a2) depositing the collector layer on the subcollector layer;
(a3) growing the field oxide layer on the collector layer; and
(a4) opening the window through the field oxide layer and thereby exposing a portion of the collector layer.

13. A method according to claim 12 wherein step (a4) comprises:
depositing a polycrystalline silicon layer over the field oxide layer;
growing a silicon dioxide layer over the polycrystalline layer,
opening the window through the field oxide, the polycrystalline, and the silicon dioxide layers; and
forming sidewalls in the window by depositing a second polycrystalline layer on exposed sides of the three layers through which the window extends.

14. A method according to claim 11 wherein step (a) comprises:
(a1) creating the subcollector layer on the substrate:
(a2) growing the field oxide layer over the subcollector layer.
(a3) opening the window through the field oxide layer and thereby exposing a portion of the subcollector layer; and
(a4) depositing the collector layer over the exposed portion of the subcollector layer in the window.

15. A method according to claim 14 and further comprising, between steps (a) and (b), the step of forming a nitride layer (110) over the field oxide layer (106) such that the nitride layer lies between the field oxide layer and the silicon-germanium layer (114).

16. A method according to claim 14 and further comprising, between steps (a) and (b), the step of forming a polycrystalline silicon layer (310) over the field oxide layer (306) such that the polycrystalline layer lies between the field oxide layer and the silicon-germanium layer (312).

17. A method according to claim 14 wherein step (b)comprises:

forming an annular polycrystalline layer (420) over the field oxide layer (406) adjacent the window;

forming an oxide layer (412) that extends laterally outward from the annular polycrystalline layer; and

non-selectively depositing a silicon-germanium layer (414) over the annular polycrystalline layer and that portion of the collector layer which is accessible through the window, and limiting the lateral extent of the silicon-germanium layer such that the silicon germanium layer does not overlie the oxide layer (412).

18. A method according to any of claims 11 through 17 wherein the substrate comprises P type silicon, the subcollector layer comprises N+ type silicon, the collector layer comprises N- type silicon, and the silicon-germanium layer comprises P type material.

19. A method according to any of claims 11 through 17 and further comprising, between steps (b) and (c), the step of depositing a silicon emitter layer (34,116) over the silicon-germanium layer.

20. A method according to claim 19 wherein the substrate comprises P type silicon, the subcollector layer comprises N+ type silicon the collector layer comprises N-type silicon, the silicon-germanium layer comprises P type material and the emitter layer comprises N type silicon.

EP 0 430 279 A2

Fig. 1

Fig. 10a

Fig. 10b

**Fig. 2**

**Fig. 3**

**Fig. 4**

**Fig. 5**

**Fig. 6**

**Fig. 7**

**Fig. 8**

**Fig. 9**

Fig. 11

Fig. 12

Fig. 13

Fig. 14

**Fig. 15**

**Fig. 16**

**Fig. 17**

**Fig. 18**

**Fig. 19**

**Fig. 20**

**Fig. 21a**

**Fig. 21b**

EP 0 430 279 A2

Fig. 22

Fig. 23

Fig. 24

Fig. 25